# EUROPEAN PATENT APPLICATION

(11) **EP 3 588 581 A1**
(43) Date of publication of application: **01.01.2020**
(21) Application number: 17897873.0
(22) Date of filing: 10.08.2017
(51) Int. Cl.: H01L 31/0224, H01L 31/05, H01L 31/18

(54) **BACK-CONTACT SOLAR CELL STRING AND PREPARATION METHOD THEREFOR, MODULE AND SYSTEM**

(30) Priority: 24.02.2017 CN 201710103098
(71) Applicant: Jolywood (Taizhou) Solar Technology Co., Ltd., Taizhou, Jiangsu 225500 (CN)
(72) Inventor: LIN, Jianwei, Taizhou Jiangsu 225500 (CN); LIU, Zhifeng, Taizhou Jiangsu 225500 (CN); JI, Genhua, Taizhou Jiangsu 225500 (CN); ZHANG, Kangping, Taizhou Jiangsu 225500 (CN); LIU, Yong, Taizhou Jiangsu 225500 (CN)
(74) Representative: Plasseraud IP
(86) International application number: PCT/CN2017/000515
(87) International publication number: WO 2018/152659

(57) **Abstract**

The present application relates to a back-contact solar cell string and a preparation method thereof, a solar cell module and a solar cell system. The back-contact solar cell string comprises back-contact solar cells and a conducting member configured to electrically connect the back-contact solar cells. Emitter segmented electrodes in an emitter p+ regions and base segmented electrodes in a base n+ regions are arranged on the back surface of the back-contact solar cell, emitter wire electrodes are arranged on the emitter segmented electrodes and base wire electrodes are arranged on the base segmented electrodes, the emitter wire electrodes and the base wire electrodes extend from a cell in opposite directions, and the emitter wire electrodes of the back-contact solar cell are electrically connected to the base wire electrodes of an adjacent back-contact solar cell by the conducting member. The present application has the following beneficial effects: the operation is simple and does not require high-precision alignment and welding devices, the transverse transport loss of carriers between electrodes is reduced, the fill factor of the cell is increased, and the short-circuit current of the module is reduced to thus significantly reduce the packaging loss of the module.

## Description

### TECHNICAL FIELD

The present application relates to the technical field of solar cells and in particular to a back-contact solar cell string and a preparation method thereof, a solar cell module and a solar cell system.

### BACKGROUND

Solar cells are semiconductor devices that convert light energy into electrical energy. Low production cost and high energy conversion efficiency have always been the goal pursued in the solar cell industry. For a conventional solar cell, the emitter contact electrodes and the base contact electrodes are respectively located on front and back sides of the cell. The front side of the cell is a light receiving surface, and the coverage of the metal emitter contact electrodes on the front side will cause part of incident sunlight to be reflected by the metal electrodes, causing certain optical loss. For a common monocrystalline silicon solar cell, the coverage area of the metal electrodes on the front side is about 7%. Reducing the coverage of the metal electrodes on the front side can directly improve the energy conversion efficiency of the cell. A narrow back-contact cell is a cell in which both the emitter contact electrodes and the base contact electrodes are placed on the back surface (not the light-receiving surface) of the cell, with the light-receiving surface of the cell not shielded by any metal electrode. Thus, the short-circuit current of the cell is effectively increased, and the energy conversion efficiency of the cell is improved.

Solar cells with a back-contact structure are cells with highest energy conversion efficiency, among the crystalline silicon solar cells produced by solar cell industrialization. They have been favored due to high conversion efficiency and low component packaging cost. In the conventional back-contact solar cell fabrication process, the metallization process is mostly realized by electroplating which is complicated. This method works well in reducing the series resistance of the back-contact cells and increasing the open-circuit voltage of the cells. However, the method has complicated processes, the discharged waste may seriously pollute the environment, and it is not compatible with the mainstream metallization methods for the current industrial production. Therefore, it is not conducive to low-cost industrialization. Meanwhile, in the process of packaging back-contact cells into a module, it is very difficult to realize alignment and welding between adjacent cells due to a large number of emitter and base electrodes and the small line width. On the other hand, in the process of packaging cells into a module, the power loss is mostly caused by the welding resistance and the ribbon resistance. The higher the short-circuit current of a single cell, the greater the power loss.

### SUMMARY

The objective of the present application is to provide a back-contact solar cell string with high conversion efficiency, low module loss, no alignment and welding required, and saved Ag paste cost, and a preparation method thereof, a solar cell module and a solar cell system.

The present application provides a back-contact solar cell string. The technical solution will be described below.

The back-contact solar cell string comprises back-contact solar cells and a conducting member configured to electrically connect the back-contact solar cells, with emitter p+ regions and base n+ regions being alternately arranged on a back surface of each of the back-contact solar cells, wherein emitter segmented electrodes in the emitter p+ regions and base segmented electrodes in the base n+ regions are further arranged on the back surface of the back-contact solar cell, emitter wire electrodes are arranged on the emitter segmented electrodes and base wire electrodes are arranged on the base segmented electrodes, the emitter wire electrodes and the base wire electrodes extend from a cell in opposite directions, and the emitter wire electrodes of the back-contact solar cell are electrically connected to the base wire electrodes of an adjacent back-contact solar cell by the conducting member.

Wherein, emitter thermosensitive conducting layers are arranged on the emitter segmented electrodes and base thermosensitive conducting layers are arranged on the base segmented electrodes; and, emitter wire electrodes are laid on the emitter thermosensitive conducting layers of the emitter segmented electrodes correspondingly, and base wire electrodes are laid on the base thermosensitive conducting layers of the base segmented electrodes correspondingly.

Wherein, the thermosensitive conducting layers are Sn paste conducting layers.

Wherein, the conducting member is coated with conducting adhesive, and the conducting member is made of metallic material.

Wherein, both the emitter segmented electrodes and the base segmented electrodes consist of discontinued dots, centers of which are in a same line; or, both the emitter segmented electrodes and the base segmented electrodes consist of discontinued lines; or, both the emitter segmented electrodes and the base segmented electrodes consist of discontinued dots which are arranged in a dislocation manner; and both the emitter segmented electrodes and the base segmented electrodes have a width not greater than that of doped regions where the emitter and the base are located.

Wherein, the back-contact solar cell has a resistivity of 1-30 Ω•cm and a thickness of 50-300 µm ; the emitter p+ regions and the base n+ regions of the back-contact solar cell, which are in a strip shape, are alternately arranged on the back surface of the cell; and passivation layers are further arranged in the emitter p+ regions and the base n+ regions to passivate the surface of the cell.

Wherein, the emitter p+ regions have a width of 200-3000 µm and the base n+ regions have a width of 100-2000 µm.

Wherein, the back-contact solar cells are narrow back-contact solar cells obtained by cutting a cell at equal spacing.

Wherein, the emitter segmented electrodes are Ag-AI paste electrodes and the base segmented electrodes are Ag paste electrodes, and the back-contact solar cells are back-contact N-type monocrystalline silicon solar cells.

Wherein, the emitter wire electrodes and the base wire electrodes extend 0.5-5 mm from the edge of the back-contact cell.

The present application further provides a method for preparing a back-contact solar cell string, comprising steps of:
(1) forming, on a back surface of a solar cell substrate, emitter p+ regions and base n+ regions which are alternately arranged;
(2) printing emitter segmented electrodes in the emitter p+ regions and printing base segmented electrodes in the base n+ regions, and at the end of printing, conveying the back-contact solar cell to a conveyer-type sintering furnace to sinter it;
(3) cutting the back-contact solar cell into narrow back-contact cells in a direction perpendicular to the arrangement direction of the emitter p+ regions and base n+ regions;
(4) laying emitter wire electrodes on the emitter segmented electrodes correspondingly, and laying base wire electrodes on the base segmented electrodes correspondingly, with one end of the emitter wire electrodes extending from the back-contact cell and the base wire electrodes extending from the back-contact cell in an opposite direction; and
(5) successively arranging the narrow back-contact cells, and laying a conducting member at a joint of adjacent cells so that the emitter wire electrodes and the base wire electrodes of adjacent back-contact solar cells are electrically connected by the conducting member and conducting adhesive to form a solar cell string.

Wherein, after the step (3) and before the step (4), the method further comprises a step (3)':
(3)': printing emitter thermosensitive conducting layers on the emitter segmented electrodes and printing base thermosensitive conducting layers on the base segmented electrodes; and
the step (4) becomes a step (4)':
(4)': laying emitter wire electrodes on the emitter thermosensitive conducting layers of the emitter segmented electrodes correspondingly, and laying base wire electrodes on the base thermosensitive conducting layers of the base segmented electrodes correspondingly.

Wherein, in the step (2), the peak temperature for sintering is 850-950°C.

Wherein, the emitter wire electrodes and the base wire electrodes extend 0.5-5 mm from the edge of the back-contact cell.

The present application further provides a solar cell module, comprising a solar cell string, wherein the solar cell string is the back-contact solar cell string described above.

The present application further provides a solar cell system, comprising more than one solar cell module, wherein the solar cell module is the solar cell module described above.

The present application has the following beneficial effects:
the use of wires, instead of the conventional Ag electrodes, as electrodes on the back side of the back-contact cell saves the Ag paste cost; by extending the emitter and base wire electrodes from the cell in opposite directions and electrically connecting the emitter wire electrodes and the base wire electrodes of adjacent cells by the conducting member, the serial connection of back-contact cells is realized, and the operation is simple and does not require high-precision alignment and welding device; the conducting member further plays a role of transverse current convergence, so that the transverse transport loss of carriers between electrodes is reduced, and the fill factor of the cell is increased; and, since the narrow cells, which are not integrated in a whole, are connected serially, the short-circuit current of the module is reduced to thus significantly reduce the packaging loss of the module.

### BRIEF DESCRIPTION OF THE DRAWINGS

Fig. 1 is a structure diagram of the back surface, at the end of the step 1 of a method for preparing a back-contact solar cell string according to Embodiments 1 and 2 of the present application;
Figs. 2a, 2b and 2c are structure diagrams of the back surface, at the end of the step 2 of the method for preparing a back-contact solar cell string according to Embodiments 1 and 2 of the present application;
Fig. 3 is a schematic view of the laser cutting direction in the step 3 of the method for preparing a back-contact solar cell string according to Embodiments 1 and 2 of the present application;
Fig. 4 is a structure diagram of the back surface, at the end of the step 3 of the method for preparing a back-contact solar cell string according to Embodiments 1 and 2 of the present application;
Fig. 5 is a structure diagram of the back surface, at the end of the step 3' of the method for preparing a back-contact solar cell string according to Embodiment 2 of the present application;
Fig. 6 is a partially-enlarged structure diagram of the back surface, at the end of the step 3' of the method for preparing a back-contact solar cell string according to Embodiment 2 of the present application;
Fig. 7 is a structure diagram of the back surface, at the end of the step 4 of the method for preparing a back-contact solar cell string according to Embodiment 1 of the present application;
Fig. 8 is a schematic view of the string of back-contact solar cells which are serially connected by the conducting member, in the step 5 of the method for preparing a back-contact solar cell string according to Embodiment 1 of the present application;
Fig. 9 is a structure diagram of the back surface, at the end of the step 4' of the method for preparing a back-contact solar cell string according to Embodiment 2 of the present application; and
Fig. 10 is a schematic view of the string of back-contact solar cells which are serially connected by the conducting member, in the step 5 of the method for preparing a back-contact solar cell string according to Embodiment 2 of the present application.

### DETAILED DESCRIPTION

The present application will be described below in detail with reference to the accompanying drawings by embodiments. It is to be noted that the embodiments to be described are merely provided for understanding of the present application and not intended to limit the present application.

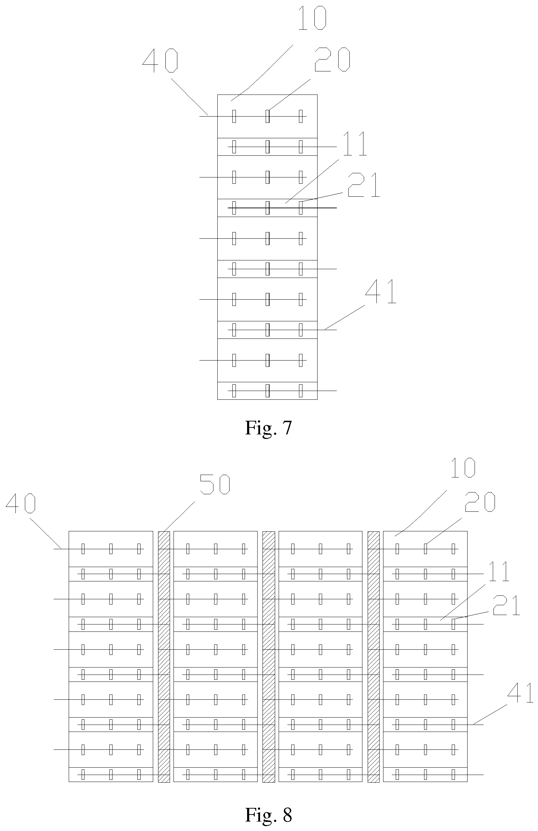

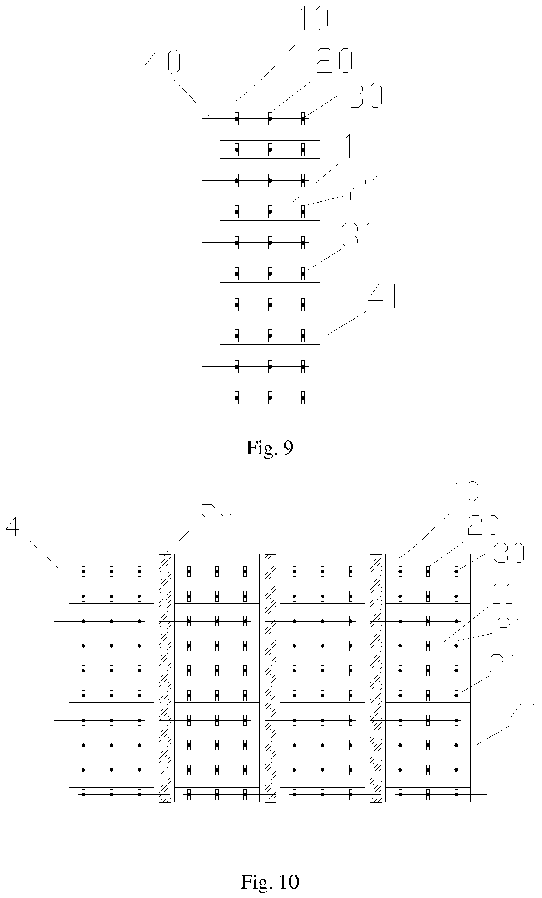

Referring to Figs. 7-10, a back-contact solar cell string in this embodiment comprises back-contact solar cells and a conducting member configured to electrically connect the back-contact solar cells. Emitter p+ regions 10 and base n+ regions 11 are alternately arranged on a back surface of each of the back-contact solar cells. Emitter segmented electrodes 20 are arranged in the emitter p+ regions 10, base segmented electrodes 21 are arranged in the base n+ regions 11, emitter wire electrodes 40 are arranged on the emitter segmented electrodes 20, and base wire electrodes 41 are arranged on the base segmented electrodes 21. Or, emitter thermosensitive conducting layers 30 are arranged on the emitter segmented electrodes 20, base thermosensitive conducting layers 31 are arranged on the base segmented electrodes 21, emitter wire electrodes 40 are laid on the emitter thermosensitive conducting layers 30 of the emitter segmented electrodes 20 correspondingly, and base wire electrodes 41 are laid on the base thermosensitive conducting layers 31 of the base segmented electrodes 21 correspondingly. The emitter wire electrodes 40 and the base wire electrodes 41 extend from a cell in opposite directions, and the emitter wire electrodes 40 are electrically connected to the base wire electrodes 41 of an adjacent back-contact solar cell by the conducting member 50. After the above operation, the structure of the back surface of the cell is shown in Figs. 8 and 10. For the back-contact solar cell string in this embodiment, the Ag paste cost is saved; by extending the emitter and base wire electrodes from the cell in opposite directions and electrically connecting the emitter wire electrodes and the base wire electrodes of adjacent cells by the conducting member, the serial connection of back-contact cells is realized, and the operation is simple and does not require high-precision alignment and welding device; and the conducting member further plays a role of transverse current convergence, so that the transverse transport loss of carriers between electrodes is reduced, and the fill factor of the cell is increased.

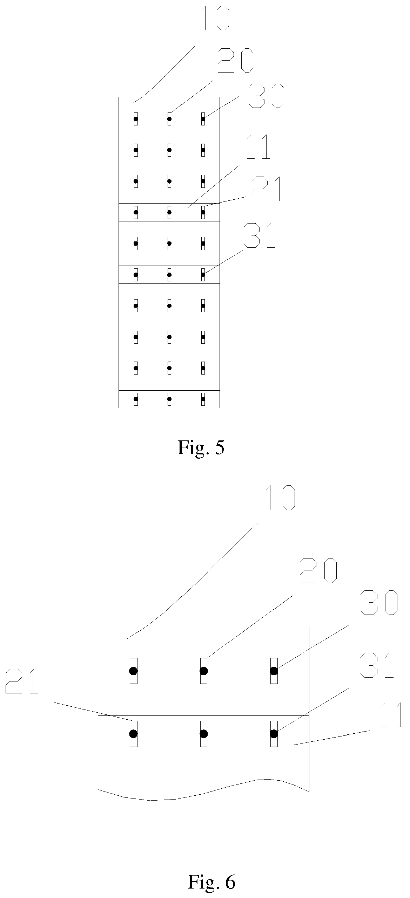

Preferably, the thermosensitive conducting layers are Sn paste conducting layers. As the inking patterns for Sn paste, circles or lines may be used, which have a width not greater than that of their doped regions. When printing, it is necessary to ensure that the inked emitter thermosensitive conducting layers 30 are located on the emitter segmented electrodes 20 and that the inked base thermosensitive conducting layers 31 are located on the base segmented electrodes 21, as shown in Figs. 5 and 6.

Preferably, the conducting member 50 is coated with conducting adhesive, and the conducting member 50 may be made of Cu or Al or other conducting material.

Preferably, the back-contact solar cells are two to six narrow solar cells obtained by cutting a cell, which is 6 inches, at equal spacing. The solar cells have a width of 20-80 mm, preferably 26-78 mm, and a length of 156-162 mm. Since the narrow cells, which are not integrated in a whole, are connected serially, the short-circuit current of the module is reduced to thus significantly reduce the packaging loss of the module.

Preferably, both the emitter segmented electrodes 20 and the base segmented electrodes 21 consist of discontinued dots, centers of which are in a same line; or, consist of discontinued lines; or, consist of discontinued dots which are arranged in a dislocation manner; and both the emitter segmented electrodes 20 and the base segmented electrodes 21 have a width not greater than that of doped regions where the emitter and the base are located.

Preferably, a passivation and anti-inflection film is formed on the front surface of the back-contact solar cell and a passivation film is formed on the back surface thereof. The back-contact solar cell has a resistivity of 1-30 Ω•cm and a thickness of 50-300 µm. Each emitter p+ region 10 has a width of 200-3000 µm and each base n+ region 11 has a width of 100-2000 µm. The emitter segmented electrodes 20 are Ag-AI paste electrodes and the base segmented electrodes 21 are Ag paste electrodes, and the back-contact solar cells are back-contact N-type monocrystalline silicon solar cells. The emitter p+ regions 10 and the base n+ regions 11, which are in a narrow shape, are alternately distributed on the solar cell substrate. One end of the emitter wire electrodes 40 extends from the narrow back-contact cell and the base wire electrodes 41 extend from the narrow back-contact cell in an opposite direction. The emitter wire electrodes 40 and the base wire electrodes 41 extend 0.5-5 mm from the edge of the narrow back-contact cell.

### Embodiment 1:

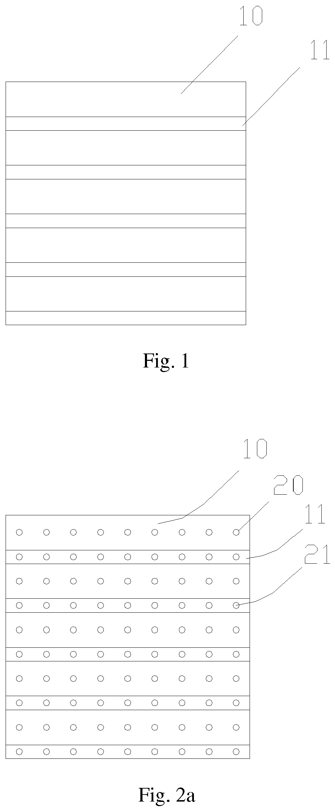

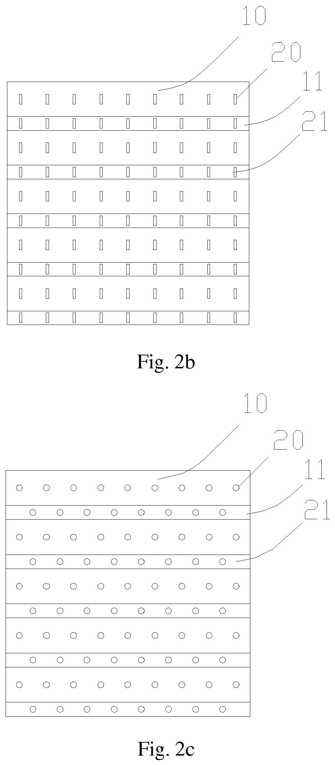

The method for preparing a back-contact solar cell string in this embodiment comprises the following steps.
(1): A back-contact solar cell having emitter p+ regions 10 and base n+ regions 11 alternately arranged on a back surface of a silicon wafer is prepared. In this embodiment, N-type monocrystalline silicon substrate is used, which has a resistivity of 1-30 Ω•cm and a thickness of 50-300 µm. Before used, the N-type monocrystalline silicon substrate is textured on its surface. Then, p+ regions 10 and the base n+ regions 11 are alternately arranged on the back surface of the cell by processes such as diffusion or ion implantation, masking, and etching. Then, both the back surface and the front surface of the cell are passivated and optically treated for anti-reflection by dielectric films such as silicon oxides, silicon nitrides and aluminum oxides, to form a desired solar cell having emitter p+ regions 10 and base n+ regions 11 alternately arranged on the back surface of the silicon wafer, wherein each emitter p+ region 10 has a width of 200-3000 µm and each base n+ region 11 has a width of 100-2000 µm. After the above operation, the structure of the back surface of the cell is shown in Fig. 1.
(2): Emitter segmented electrodes 20 are printed in the emitter p+ regions 10 and base segmented electrodes 21 are printed in the base n+ regions 11. Both the emitter segmented electrodes 20 and the base segmented electrodes 21 consist of discontinued dots (as shown in Fig. 2a), centers of which are in a same line. Both the emitter segmented electrodes 20 and the base segmented electrodes 21 may consist of discontinued lines (as shown in Fig. 2b). Patterns in the emitter segmented electrodes 20 and the base segmented electrodes 21 may be regular arrays. As shown in Fig. 2c, both the emitter segmented electrodes 20 and the base segmented electrodes 21 may consist of discontinued dots which are arranged in a dislocation manner. However, both the emitter segmented electrodes 20 and the base segmented electrodes 21 have a width not greater than that of their doped regions.

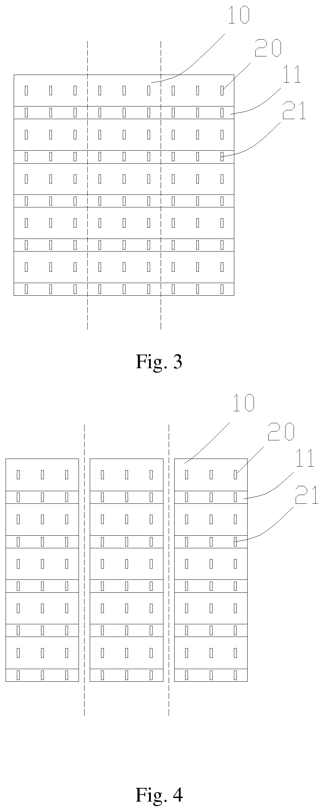

The paste for printing the emitter segmented electrodes 20 is Ag-AI paste and the paste for printing the base segmented electrodes 21 is Ag paste.
(3): As shown in Fig. 3, the back-contact solar cell treated in the step (2) is equally cut, by a laser cutter, into three narrow back-contact cells 156 mm * 52 mm. The cutting direction is perpendicular to the arrangement direction of the emitter p+ regions and base n+ regions. Or, the back-contact solar cell may be equally cut into two to six narrow back-contact cells. After the above operation, the structure of the back surface of the cell is shown in Fig. 4.
(4): As shown in Fig. 7, emitter wire electrodes 40 are laid on the emitter segmented electrodes 20 correspondingly, and base wire electrodes 41 are laid on the base segmented electrodes 21 correspondingly. One end of the emitter wire electrodes 40 extends from the narrow back-contact cell and the base wire electrodes 41 extend from the narrow back-contact cell in an opposite direction. The emitter wire electrodes 40 and the base wire electrodes 41 extend 0.5-5 mm from the edge of the narrow back-contact cell. Both the emitter wire electrodes 40 and the base wire electrodes 41 have a circular cross section having a diameter of 40-80 µm. Both the emitter wire electrodes 40 and the base wire electrodes 41 may have a square or triangular cross section. The emitter wire electrodes 40 and the base wire electrodes 41 may be made of Cu wires, Ag-coated Cu wires or Sn-coated Cu wires. After laying the emitter and base wire electrodes is completed, the narrow back-contact cell is conveyed to a conveyer-type sintering furnace to sinter it. The peak temperature for sintering is 850-950°C. After this step, the structure of the back surface of the cell is shown in Fig. 7.
(5): Several narrow back-contact cells, which have been treated in the step 4, are successively arranged. A conducting member 50 is laid at a joint of adjacent cells. The conducting member 50 is coated with conducting adhesive. After laying the conducting member is completed, the emitter wire electrodes 40 and the base wire electrodes 41 of adjacent cells are electrically connected by the conducting member 50 and conducting adhesive (the connected view is shown in Fig. 8). The conducting member 50 may be made of Cu or Al or other conducting material. So far, the preparation of a back-contact solar cell string of the present application is completed.

### Embodiment 2:

The method for preparing a back-contact solar cell string in this embodiment comprises the following steps.

The steps (1) to (3) and the step (5) are the same as those in Embodiment 1 and will not be repeatedly described here.
(3)': Sn paste is printed on the emitter segmented electrodes 20 of the narrow back-contact cell already treated in the step 3 to form emitter thermosensitive conducting layers 30, and Sn paste is printed on the base segmented electrodes 21 to form base thermosensitive conducting layers 31. As the inking patterns for Sn paste, circles or lines may be used. The inking patterns have a width not greater than that of their doped regions. When printing, it is necessary to ensure that the inked emitter thermosensitive conducting layers 30 are located on the emitter segmented electrodes 20 and that the inked base thermosensitive conducting layers 31 are located on the base segmented electrodes 21. The partially-enlarged structure diagram after the printing is shown in Fig. 6. After this step, the structure of the back surface of the cell is shown in Fig. 5.
(4)': As shown in Fig. 9, emitter wire electrodes 40 are laid on the emitter thermosensitive conducting layers 30 of the emitter segmented electrodes 20 correspondingly, and base wire electrodes 41 are laid on the base thermosensitive conducting layers 31 of the base segmented electrodes 21 correspondingly. One end of the emitter wire electrodes 40 extends from the narrow back-contact cell and the base wire electrodes 41 extend from the narrow back-contact cell in an opposite direction. The emitter wire electrodes 40 and the base wire electrodes 41 extend 0.5-5 mm from the edge of the narrow back-contact cell. Both the emitter wire electrodes 40 and the base wire electrodes 41 have a circular cross section having a diameter of 40-80 µm. Both the emitter wire electrodes 40 and the base wire electrodes 41 may have a square or triangular cross section. The emitter wire electrodes 40 and the base wire electrodes 41 may be made of Cu wires, Ag-coated Cu wires or Sn-coated Cu wires. After the laying is completed, the back-contact solar cell is heated, so that the emitter wire electrodes 40, the emitter thermosensitive conducting layers 30 and the emitter segmented electrodes 20 form ohmic contact, and the base wire electrodes 41, the base thermosensitive conducting layers 31 and the base segmented electrodes 21 form ohmic contact. For the purpose of heating, infrared heating is used. The peak temperature for refluxing is 183-250°C. After this step, the structure of the back surface of the cell is shown in Fig. 9.
(5) Several narrow back-contact cells, which have been treated in the step 4', are successively arranged. A conducting member 50 is laid at a joint of adjacent cells. The conducting member 50 is coated with conducting adhesive. After laying the conducting member is completed, the emitter wire electrodes 40 and the base wire electrodes 41 of adjacent cells are electrically connected by the conducting member 50 and conducting adhesive (the connected view is shown in Fig. 10). The conducting member 50 may be made of Cu or Al or other conducting material. So far, the preparation of a back-contact solar cell string of the present application is completed.

This embodiment further provides a solar cell module, comprising a solar cell string, wherein the solar cell string is the back-contact solar cell string described above.

This embodiment further provides a solar cell system, comprising more than one solar cell module, wherein the solar cell module is the solar cell module described above.

At last, it should be noted that the embodiments described above are merely provided to explain the technical solution of the present application, not to confine the protection scope of the present application. Although the present application has been explained in detail by preferred embodiments, a person of ordinary skill in the art should understand that the technical solution of the present application can be modified or equivalently replaced without departing from the essence and the scope of the technical solution of the present application.

## Claims

1. A back-contact solar cell string, comprising back-contact solar cells and a conducting member configured to electrically connect the back-contact solar cells, with emitter p+ regions and base n+ regions being alternately arranged on a back surface of each of the back-contact solar cells, wherein emitter segmented electrodes in the emitter p+ regions and base segmented electrodes in the base n+ regions are further arranged on the back surface of the back-contact solar cell, emitter wire electrodes are arranged on the emitter segmented electrodes and base wire electrodes are arranged on the base segmented electrodes, the emitter wire electrodes and the base wire electrodes extend from a cell in opposite directions, and the emitter wire electrodes of the back-contact solar cell are electrically connected to the base wire electrodes of an adjacent back-contact solar cell by the conducting member.

2. The back-contact solar cell string according to claim 1, wherein emitter thermosensitive conducting layers are arranged on the emitter segmented electrodes and base thermosensitive conducting layers are arranged on the base segmented electrodes; and, emitter wire electrodes are laid on the emitter thermosensitive conducting layers of the emitter segmented electrodes , and base wire electrodes are laid on the base thermosensitive conducting layers of the base segmented electrodes .

3. The back-contact solar cell string according to claim 2, wherein the thermosensitive conducting layers are Sn paste conducting layers.

4. The back-contact solar cell string according to claim 1, wherein the conducting member is coated with conducting adhesive, and the conducting member is made of metallic material.

5. The back-contact solar cell string according to claim 1, wherein both the emitter segmented electrodes and the base segmented electrodes consist of discontinued dots, centers of which are in a same line; or, both the emitter segmented electrodes and the base segmented electrodes consist of discontinued lines; or, both the emitter segmented electrodes and the base segmented electrodes consist of discontinued dots which are arranged in a dislocation manner; and both the emitter segmented electrodes and the base segmented electrodes have a width not greater than that of doped regions where the emitter and the base are located.

6. The back-contact solar cell string according to claim 1, wherein the back-contact solar cell has a resistivity of 1-30 Ω•cm and a thickness of 50-300 µm; the emitter p+ regions and the base n+ regions of the back-contact solar cell, which are in a strip shape, are alternately arranged on the back surface of the cell; and passivation layers are further arranged in the emitter p+ regions and the base n+ regions to passivate the surface of the cell.

7. The back-contact solar cell string according to claim 1, wherein the emitter p+ regions have a width of 200-3000 µm and the base n+ regions have a width of 100-2000 µm.

8. The back-contact solar cell string according to claim 1, wherein the back-contact solar cells are narrow back-contact solar cells obtained by cutting a cell at equal spacing.

9. The back-contact solar cell string according to claim 1, wherein the emitter segmented electrodes are Ag-AI paste electrodes and the base segmented electrodes are Ag paste electrodes, and the back-contact solar cells are back-contact N-type monocrystalline silicon solar cells.

10. The back-contact solar cell string according to any one of claims 1-9, wherein the emitter wire electrodes and the base wire electrodes extend 0.5-5 mm from the edge of the back-contact cell.

11. A method for preparing a back-contact solar cell string, comprising steps of:
(1) forming, on a back surface of a solar cell substrate, emitter p+ regions and base n+ regions which are alternately arranged;
(2) printing emitter segmented electrodes in the emitter p+ regions and printing base segmented electrodes in the base n+ regions, and at the end of printing, conveying the back-contact solar cell to a conveyer-type sintering furnace to sinter it;
(3) cutting the back-contact solar cell into narrow back-contact cells in a direction perpendicular to the arrangement direction of the emitter p+ regions and base n+ regions;
(4) laying emitter wire electrodes on the emitter segmented electrodes , and laying base wire electrodes on the base segmented electrodes , with one end of the emitter wire electrodes extending from the back-contact cell and the base wire electrodes extending from the back-contact cell in an opposite direction; and
(5) successively arranging the narrow back-contact cells, and laying a conducting member at a joint of adjacent cells so that the emitter wire electrodes and the base wire electrodes of adjacent back-contact solar cells are electrically connected by the conducting member and conducting adhesive to form a solar cell string.

12. The method for preparing a back-contact solar cell string according to claim 11, wherein, after the step (3) and before the step (4), the method further comprises a step (3)':
(3)': printing emitter thermosensitive conducting layers on the emitter segmented electrodes and printing base thermosensitive conducting layers on the base segmented electrodes; and
the step (4) becomes a step (4)':
(4)': laying emitter wire electrodes on the emitter thermosensitive conducting layers of the emitter segmented electrodes correspondingly, and laying base wire electrodes on the base thermosensitive conducting layers of the base segmented electrodes correspondingly.

13. The method for preparing a back-contact solar cell string according to claim 11, wherein, in the step (2), the peak temperature for sintering is 850-950 °C.

14. The method for preparing a back-contact solar cell string according to claim 11, wherein the emitter wire electrodes and the base wire electrodes extend 0.5-5 mm from the edge of the back-contact cell.

15. A solar cell module, comprising a solar cell string, wherein the solar cell string is the back-contact solar cell string according to any one of claims 1-10.

16. A solar cell system, comprising more than one solar cell module, wherein the solar cell module is the solar cell module according to claim 15.
